# EUROPEAN PATENT APPLICATION

(11) **EP 4 582 897 A1**
(43) Date of publication of application: **09.07.2025**
(21) Application number: 22960145.5
(22) Date of filing: 29.09.2022
(51) Int. Cl.: G05F 1/56, G05F 1/00, H03K 17/16, H03K 17/24, G06F 1/26

(54) **CONTROL DEVICE, CONTROL SYSTEM, AND CARRIER VEHICLE**

(71) Applicant: Shenzhen Yinwang Intelligent Technologies Co., Ltd., Shenzhen, Guangdong 518129 (CN)
(72) Inventor: LI, Zengshan, Shenzhen, Guangdong 518129 (CN); WANG, Hongzhi, Shenzhen, Guangdong 518129 (CN); LUO, Peng, Shenzhen, Guangdong 518129 (CN)
(74) Representative: Pfenning, Meinig & Partner mbB
(86) International application number: PCT/CN2022/122884
(87) International publication number: WO 2024/065509

(57) **Abstract**

A control apparatus, a control system, and a carrier are provided, and belong to the field of electronic technologies. A first isolation unit in the control system can receive a first level signal output by a first control unit and a second level signal output by a first controlled unit, and can output a first control signal to the first controlled unit. The first controlled unit can output the second level signal to the first isolation unit under an action of the first control signal. Based on this, even if the first control unit is faulty, the first isolation unit can continue to output the first control signal to the first controlled unit based on the second level signal output by the first controlled unit. This implements isolation of a fault of the first control unit, and effectively improves reliability of the control system.

## Description

### TECHNICAL FIELD

This application relates to the field of electronic technologies, and in particular, to a control apparatus, a control system, and a carrier.

### BACKGROUND

In the field of electronic technologies, a board-level design generally includes modules such as a computing unit, a management unit, and a power supply unit, and time sequence management, diagnosis, detection, and the like of a board are uniformly processed by a control unit (or the management unit). When the control unit is abnormal, a product function loss is caused. Therefore, product reliability needs to be improved.

### SUMMARY

This application provides a control apparatus, a control system, and a carrier, to improve product reliability.

According to a first aspect, a control system is provided, including a first control unit, a first isolation unit, and a first controlled unit. The first control unit is connected to the first isolation unit, and is configured to output a first level signal to the first isolation unit. The first isolation unit has a first input end, a second input end, and an output end, and the first isolation unit is configured to: receive the first level signal and a second level signal by using the first input end and the second input end of the first isolation unit respectively, and output a first control signal to the first controlled unit by using the output end of the first isolation unit. The first controlled unit is configured to output the second level signal to the second input end of the first isolation unit under an action of the first control signal.

In the solution provided in this application, even if the first control unit is faulty, the first isolation unit can still continue to output the first control signal to the first controlled unit based on the second level signal output by the first controlled unit, to control the first controlled unit. In this way, this implements isolation of the fault of the first control unit, and effectively improves reliability of the control system.

Optionally, the first isolation unit may include a first switch and a logical operation circuit, the first switch has a first end and a second end, and the logical operation circuit has a first input end, a second input end, and an output end. The first input end of the logical operation circuit serves as the first input end of the first isolation unit, and is configured to receive the first level signal as a first input signal. The first end of the first switch serves as the second input end of the first isolation unit, and is configured to receive the second level signal; the second end of the first switch is connected to the second input end of the logical operation circuit, and is configured to output a second input signal to the second input end of the logical operation circuit when the first switch is turned on. The logical operation circuit is configured to: perform a logical operation on the first input signal and the second input signal, and output the first control signal by using the output end.

When either of the first input signal and the second input signal is at a valid level, a level of the first control signal output by the logical operation circuit may be a valid level. When both the first input signal and the second input signal are at an invalid level, the level of the first control signal output by the logical operation circuit may be an invalid level.

Optionally, the valid level of the first control signal may be a high level relative to the invalid level, and the valid levels of the first input signal and the second input signal may also be high levels relative to the invalid level. Correspondingly, the logical operation circuit is configured to perform an OR operation on the first input signal and the second input signal.

It can be learned based on operation logic of the OR operation that, when either of the first input signal and the second input signal is at a high level, the first control signal output by the logical operation circuit is at a high level; or when the first input signal and the second input signal are each at a low level, the first control signal output by the logical operation circuit is at a low level.

Optionally, the logical operation circuit may be an OR gate. Structure complexity and costs of the control system can be effectively reduced by using the OR gate as the logical operation circuit.

Optionally, the valid level of the first control signal may be a low level relative to the invalid level, and the valid levels of the first input signal and the second input signal may be high levels relative to the invalid level. Correspondingly, the logical operation circuit may be configured to perform an OR operation and a NOT operation on the first input signal and the second input signal in sequence.

Based on this, when either of the first input signal and the second input signal is at a high level, the first control signal output by the logical operation circuit is at a low level; or when the first input signal and the second input signal each are at a low level, the first control signal output by the logical operation circuit is at a high level.

Optionally, the logical operation circuit may include an OR gate and a NOT gate. Two input ends of the OR gate are respectively the first input end and the second input end of the logical operation circuit, an output end of the OR gate is connected to an input end of the NOT gate, and an output end of the NOT gate is the output end of the logical operation circuit.

Optionally, the first switch may include a transistor or a field-effect transistor. Using the transistor or the field-effect transistor as the first switch can effectively simplify structure complexity of the control system, and reduce costs of the control system.

Optionally, the control system may further include a second control unit. The logical operation circuit further has a third input end; and an output end of the second control unit is connected to the third input end, and is configured to output a third level signal to the logical operation circuit as a third input signal of the logical operation circuit.

Because the second control unit can output the third level signal to the logical operation circuit, the logical operation circuit may further output the first control signal to the first controlled unit under an action of the third level signal. In this way, this effectively improves flexibility of controlling the first controlled unit. For example, after the first control unit is faulty, the second control unit may output the third level signal of the valid level, so that the logical operation circuit outputs the first control signal of the valid level to the first controlled unit. This can help operation and maintenance personnel or research and development personnel locate the fault in the control system.

Optionally, the control system may further include a second control unit. The first switch further has a third end; and an output end of the second control unit may be connected to the third end of the first switch, and is configured to control connected/disconnected states of the first end and the second end of the first switch.

After the second control unit controls each of the first end and the second end of the first switch to be disconnected, the first switch cannot output the second input signal to the logical operation circuit based on the second level signal output by the first controlled unit. Correspondingly, the logical operation circuit no longer outputs the first control signal based on the second input signal, so that a state of the first controlled unit can be unlocked.

Optionally, the control system may further include a communication unit. The communication unit is connected to an input end of a second control unit, and is configured to output a fault detection instruction to the second control unit.

The communication unit may include a wired connector and/or a wireless communication module. The second control unit may control, based on the fault detection instruction, each of the first end and the second end of the first switch to be disconnected, and output the third level signal of the valid level to the logical operation circuit.

Optionally, the control system may include a first domain and a second domain, the second domain is used to perform redundancy backup for some or all functions of the first domain, the first control unit belongs to the first domain, and the first controlled unit belongs to the second domain.

Optionally, the control system may include a first power domain and a second power domain, and the first control unit belongs to the first power domain. The first controlled unit is a power supply unit of the second power domain, and the first control signal is used to control the power supply unit of the second power domain to be powered on or off. The first control unit may be supplied with power by a power supply unit of the first power domain.

Optionally, the first power domain may further include one or more of the second control unit, a first computing unit, and a first storage unit, and the power supply unit of the first power domain is further configured to supply power to the one or more of the second control unit, the first computing unit, and the first storage unit.

For example, the first power domain may further include the second control unit, the first computing unit, and the first storage unit, that is, both the first control unit and the second control unit belong to the first power domain.

Optionally, the control system may further include a third power domain. The second control unit may belong to the third power domain, and is supplied with power by a power supply unit of the third power domain. It may be understood that, when the power supply unit of any power domain is faulty, the faulty power supply unit cannot supply power to another functional unit of the power domain, and consequently, the another functional unit is abnormally powered off. Because the first control unit and the second control unit belong to two different power domains, a case in which the two control units are abnormally powered off at the same time because the power supply unit of the specific power domain is faulty can be effectively avoided.

Optionally, the control system may further include a second computing unit and/or a second storage unit. The power supply unit of the second power domain is configured to supply power to the second computing unit and/or the second storage unit.

When the first control signal is at the invalid level, the power supply unit of the second power domain keeps in a power-off state, and the second computing unit and/or the second storage unit of the second power domain also remain/remains in a power-off state. When the first control signal is at the valid level, the power supply unit of the second power domain can be powered on under control of the first control signal, and supply power to the second computing unit and/or the second storage unit; and the second computing unit and/or the second storage unit can remain in a power-on state.

Optionally, the power supply unit of the second power domain may include a first voltage conversion unit and a second voltage conversion unit, and the control system may further include a second isolation unit. The first isolation unit is configured to output the first control signal to the first voltage conversion unit. The first control unit is further connected to the second isolation unit, and is configured to output a fourth level signal to the second isolation unit. The second isolation unit has an input end and an output end; the second isolation unit is configured to: receive the fourth level signal by using the input end of the second isolation unit, and output, under an action of the fourth level signal, the second control signal to the second voltage conversion unit by using the output end of the second isolation unit; and the second control signal is used to control the second voltage conversion unit to be powered on or powered off.

When the fourth level signal is at a valid level, the second control signal output by the second isolation unit may be at an invalid level, and the second voltage conversion unit may remain in a power-off state. When the fourth level signal is at an invalid level, the second control signal output by the second isolation unit may be at a valid level, and the second voltage conversion unit can be powered on under driving of the second control signal of the valid level. When the first control unit is faulty or is abnormally powered off, the fourth level signal output by the first control unit is at the invalid level. Therefore, the second isolation unit may continuously output the second control signal of the valid level, so that the second voltage conversion unit remains in a power-on state. In this way, impact of the fault of the first control unit on the power-on state of the second voltage conversion unit can be avoided.

Optionally, the first control unit may be configured to output the first level signal and the fourth level signal based on a working mode of the control system.

It may be understood that, power-on/off states of the first voltage conversion unit and the second voltage conversion unit may be controlled by controlling levels of the first level signal and the fourth level signal. Therefore, when the control system is in different working modes, the first control unit may control different voltage conversion units in a third power supply unit to be powered on, so that power consumption of the control system can be effectively reduced without affecting performance of the control system.

Optionally, the second isolation unit may include a second switch, and the second switch has a first end, a second end, and a third end. The first end of the second switch serves as the input end of the second isolation unit, and is configured to receive the fourth level signal; the second end of the second switch serves as the output end of the second isolation unit, and is connected to a power supply end and an input end of the second voltage conversion unit; and the third end of the second switch is connected to a ground end.

The fourth level signal may be used to control connected/disconnected states of the second end and the third end of the second switch. In addition, when the fourth level signal is at the valid level, each of the second end and the third end of the second switch is connected. In this case, because both the power supply end and the input end of the second voltage conversion unit are connected to the ground end, the second voltage conversion unit remains in the power-off state. When the fourth level signal is at the invalid level, each of the second end and the third end of the second switch is disconnected. In this case, because the input end of the second voltage conversion unit is connected to the power supply end, the second voltage conversion unit can remain in the power-on state under driving of the power supply end.

Optionally, the first end of the second switch may be grounded by using a first resistor, and the second end of the second switch may be connected to the power supply end by using a second resistor.

Optionally, the second switch may include a transistor or a field-effect transistor. Using the transistor or the field-effect transistor as the second switch can effectively simplify structure complexity of the control system, and reduce costs of the control system.

Optionally, the first controlled unit is a computing unit, and the first control signal may be a reset signal used to control reset of the computing unit.

Optionally, the control system may further include a third isolation unit and a second controlled unit. The first control unit may be further connected to the third isolation unit, and is configured to output a fifth level signal to the third isolation unit. The third isolation unit has a first input end, a second input end, and an output end, and the third isolation unit is configured to: receive the fifth level signal and a sixth level signal by using the first input end and the second input end of the third isolation unit respectively, and output a third control signal to the second controlled unit by using the output end of the third isolation unit. The second controlled unit is configured to output the sixth level signal to the second input end of the third isolation unit under an action of the third control signal.

For a structure and a working principle of the third isolation unit, refer to the first isolation unit, and details are not described herein again. In addition, the second controlled unit may be a power supply unit, or may be another functional unit such as a computing unit.

According to a second aspect, a control apparatus is provided, including a control unit and an isolation unit. The control unit is connected to the isolation unit, and is configured to output a first level signal to the isolation unit. The isolation unit has a first input end, a second input end, and an output end, and the isolation unit is configured to: receive the first level signal by using the first input end of the isolation unit, receive, by using the second input end of the isolation unit, a second level signal output by a controlled unit, and output a control signal to the controlled unit by using the output end of the isolation unit. The control signal is used to control the controlled unit to output the second level signal.

Optionally, the isolation unit may include a switch and a logical operation circuit, the switch has a first end and a second end, and the logical operation circuit has a first input end, a second input end, and an output end. The first input end of the logical operation circuit serves as the first input end of the isolation unit, and is configured to receive the first level signal as a first input signal. The first end of the switch serves as the second input end of the isolation unit, and is configured to receive the second level signal; and the second end of the switch is connected to the second input end of the logical operation circuit, and is configured to output a second input signal to the second input end of the logical operation circuit when the switch is turned on. The logical operation circuit is configured to: perform a logical operation on the first input signal and the second input signal, and output the control signal by using the output end.

Optionally, a valid level of the control signal is a high level relative to an invalid level, and the logical operation circuit is configured to perform an OR operation on the first input signal and the second input signal. Alternatively, a valid level of the control signal is a low level relative to an invalid level, and the logical operation circuit is configured to perform an OR operation and a NOT operation on the first input signal and the second input signal in sequence.

Optionally, the switch may include a transistor or a field-effect transistor.

According to a third aspect, another control apparatus is provided, including a first control unit, a second control unit, and a latching unit. The first control unit is connected to the latching unit, and is configured to output a first level signal to the latching unit. The second control unit is also connected to the latching unit, and is configured to output a second level signal to the latching unit. The latching unit has a first input end, a second input end, and an output end, and the latching unit is configured to: receive the first level signal and the second level signal by using the first input end and the second input end of the latching unit respectively, sample and latch the second level signal under an action of the first level signal, and output a latched signal to a controlled unit by using the output end.

It can be learned from the working principle of the latching unit that, even if the first control unit is faulty, the latching unit can continue to output a latched signal to the first controlled unit. In this way, this implements isolation of the fault of the first control unit, and effectively improves reliability of the control apparatus.

The latching unit may sample and latch a level of the second level signal when the first level signal has an edge change, and output the latched signal. When the first control unit is faulty or abnormally powered off, the first level signal output by the first control unit does not have an edge change. Therefore, the first level signal does not trigger the latching unit to adjust a level of a signal output by the latching unit, and the controlled unit may continue to remain in a previous working state. In other words, the latching unit can avoid impact of the fault of the first control unit on the working state of the controlled unit, implement isolation of the fault of the first control unit, and further implement state locking of the controlled unit.

Optionally, the latching unit may include an edge trigger. The first level signal output by the first control unit may include at least one targeted edge change, and the targeted edge change may be a rising edge or a falling edge. The level of the second level signal output by the second control unit may be a valid level. The edge trigger may sample and latch a level (namely, the level of the second level signal) of the second input end when detecting that the first input end of the latching unit has a targeted edge change, and output the latched signal.

Optionally, the latching unit may further have a power supply end. The second control unit is further connected to the power supply end of the latching unit, and is configured to control a power-on/off state of the latching unit.

After the first control unit is faulty or abnormally powered off, if the latching unit needs to stop outputting a control signal, the second control unit may control the latching unit to be powered off. In this way, control of the locking unit on the controlled unit may be unlocked, that is, a state of the controlled unit can be unlocked.

According to a fourth aspect, an isolation circuit is provided, including: a logical operation circuit, having a first input end, a second input end, and an output end, where the first input end is configured to receive a first level signal as a first input signal, the second input end is configured to receive a second input signal, and the logical operation circuit is configured to: perform a logical operation on the first input signal and the second input signal, and output a first control signal by using the output end; and a switch, having a first end and a second end, where the first end is configured to receive a second level signal; the second end is connected to the first input end of the logical operation circuit, and is configured to output the second input signal to the second input end of the logical operation circuit when the switch is turned on; and the second level signal is an output of a controlled unit controlled by the first control signal.

According to a fifth aspect, a control system is provided, including the control apparatus and the controlled unit provided in the second aspect or the third aspect.

According to a sixth aspect, a central computing platform is provided, including the control system provided in any one of the foregoing aspects and at least one interface. The at least one interface may include one or more of a power interface, an Ethernet interface, a sensor interface, and the like. The central computing platform may be an intelligent central computing module or a high-performance central computing platform, and the central computing platform may be a cassette device.

According to a seventh aspect, an autonomous driving system is provided, including the central computing platform provided in the foregoing aspect, a vehicle-mounted sensor component, and a vehicle-mounted controller component. The central computing platform is configured to: process data collected by the vehicle-mounted sensor component, and control the vehicle-mounted actuator component to perform an autonomous driving operation.

According to an eighth aspect, a carrier is provided, including the control system provided in any one of the foregoing aspects. The carrier may be a vehicle, for example, may be a vehicle having an autonomous driving function.

Optionally, the carrier further includes a battery component, configured to supply power to a power supply unit in the control system.

In conclusion, this application provides the control apparatus, the control system, and the carrier. The first isolation unit in the control system can receive the first level signal output by the first control unit and the second level signal output by the first controlled unit, and can output the first control signal to the first controlled unit. The first controlled unit can output the second level signal to the first isolation unit under an action of the first control signal. Based on this, even if the first control unit is faulty, the first isolation unit can continue to output the first control signal to the first controlled unit based on the second level signal output by the first controlled unit. In this way, this implements isolation of the fault of the first control unit, and effectively improves reliability of the control system.

### BRIEF DESCRIPTION OF DRAWINGS

FIG. 1 is a diagram of a structure of a control system according to an embodiment of this application;
FIG. 2 is a diagram of a structure of another control system according to an embodiment of this application;
FIG. 3 is a diagram of a structure of a logical operation circuit according to an embodiment of this application;
FIG. 4 is a diagram of a structure of still another control system according to an embodiment of this application;
FIG. 5 is a diagram of a structure of yet another control system according to an embodiment of this application;
FIG. 6 is a diagram of a structure of still yet another control system according to an embodiment of this application;
FIG. 7 is a diagram of a structure of a second power supply unit according to an embodiment of this application;
FIG. 8 is a diagram of a structure of a further control system according to an embodiment of this application;
FIG. 9 is a diagram of a structure of a still further control system according to an embodiment of this application;
FIG. 10 is a diagram of a structure of a control apparatus according to an embodiment of this application;
FIG. 11 is a diagram of a structure of another control apparatus according to an embodiment of this application;
FIG. 12 is a diagram of structure of a central computing platform according to an embodiment of this application; and
FIG. 13 is a diagram of a structure of a carrier according to an embodiment of this application.

### DESCRIPTION OF EMBODIMENTS

The following describes in detail a control apparatus, a control system, and a carrier provided in embodiments of this application with reference to the accompanying drawings.

An embodiment of this application provides a control system. The control system may be used in a carrier. The carrier may include a road transportation means, a water transportation means, an air transportation means, an industrial device, an agricultural device, an entertainment device, or the like. For example, the carrier may be a vehicle. The vehicle is a vehicle in a broad sense, and may be a transportation means (for example, a commercial vehicle, a passenger vehicle, a motorcycle, a flight vehicle, or a train), an industrial vehicle (for example, a forklift, a trailer, or a tractor), an engineering vehicle (for example, an excavator, a bulldozer, or a crane), an agricultural device (for example, a lawn mower or a harvester), a recreation device, a toy vehicle, or the like. A type of the vehicle is not specifically limited in this embodiment of this application. For another example, the carrier may be an aircraft, a ship, or another transportation means.

Optionally, the control system may be further used in another device, for example, may be further used in a server or a network device in an information and communications technology (information and communications technology, ICT) field. It may be understood that the control system provided in this embodiment of this application may be used in various devices that have a fault isolation requirement, for example, may be used in a device that has a plurality of power domains and that needs to implement fault isolation between the power domains.

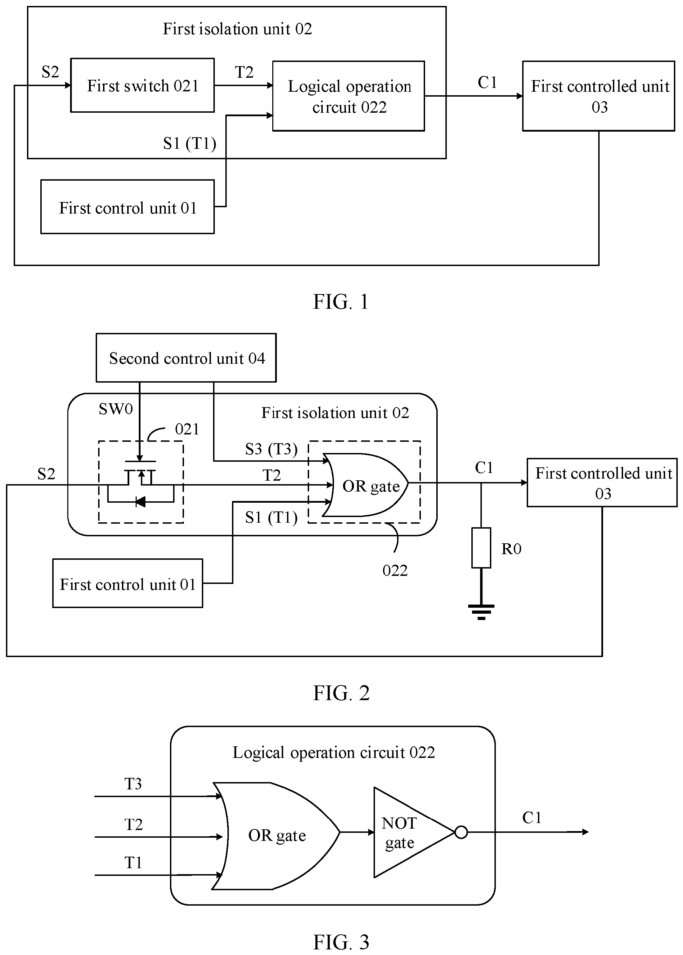

As shown in FIG. 1, the control system includes a first control unit 01, a first isolation unit 02, and a first controlled unit 03. The first control unit 01 is connected to the first isolation unit 02, and the first control unit 01 is configured to output a first level signal S1 to the first isolation unit 02.

The first isolation unit 02 has a first input end, a second input end, and an output end, and the first isolation unit 02 is configured to: receive the first level signal S1 by using the first input end, receive a second level signal S2 by using the second input end, and output a first control signal C1 to the first controlled unit 03 by using the output end.

The first controlled unit 03 is configured to output the second level signal S2 to the second input end of the first isolation unit 02 under an action of the first control signal C1.

Because the first controlled unit 03 can output the second level signal S2 under the action of the first control signal C1, even if the first control unit 01 is faulty or is abnormally powered off, the first isolation unit 02 can continue to output the first control signal C1 to the first controlled unit 03 based on the second level signal S2 received by the second input end of the first isolation unit 02.

In this embodiment of this application, the first isolation unit 02 may be configured to: when a level signal received by either of the first input end and the second input end of the first isolation unit 02 is at a valid level, output the first control signal C1 of a valid level. In addition, the first isolation unit 02 may be configured to: when level signals received by the first input end and the second input end of the first isolation unit 02 each are at an invalid level, output the first control signal C1 of an invalid level.

If the first control signal C1 output by the first isolation unit 02 is at a valid level, the first controlled unit 03 may remain in a target working state (for example, a power-on state or a reset state), and may output the second level signal S2 of a valid level to the second input end of the first isolation unit 02. If the first control signal C1 is at an invalid level, the first controlled unit 03 cannot be in the target working state, and the first controlled unit 03 stops outputting the second level signal S2, or the second level signal S2 output by the first controlled unit 03 is at an invalid level.

In this embodiment of this application, after being powered on, the first control unit 01 may output the first level signal S1 of a valid level to the first isolation unit 02. The first isolation unit 02 may output the first control signal C1 of a valid level to the first controlled unit 03 under an action of the first level signal S1 of the valid level. Further, the first controlled unit 03 may be in the target working state under control of the first control signal C1, and feed back the second level signal S2 of a valid level to the first isolation unit 02. Based on this, even if the first control unit 01 cannot continue to output the first level signal S1 of the valid level because of being faulty, being abnormally powered off, or the like, the second level signal S2 can still enable the first isolation unit 02 to continuously output the first control signal C1 of the valid level. In this way, the first controlled unit 03 can remain in the target working state. To be specific, the first isolation unit 01 can isolate a fault of the first control unit 01 under an action of the second level signal S2 output by the first controlled unit 03, to implement state self-locking of the first controlled unit 03.

Optionally, as shown in FIG. 1, the first isolation unit 02 may include a first switch 021 and a logical operation circuit 022. The first switch 021 has a first end and a second end, and the logical operation circuit 022 has a first input end, a second input end, and an output end.

The first input end of the logical operation circuit 022 serves as the first input end of the first isolation unit 02, and may be configured to receive the first level signal S1 as a first input signal T1.

The first end of the first switch 021 serves as the second input end of the first isolation unit 02, and may be configured to receive the second level signal S2. The second end of the first switch 021 is connected to the second input end of the logical operation circuit 022, and may be configured to output a second input signal T2 to the second input end of the logical operation circuit 022 when the first switch 021 is turned on.

The logical operation circuit 022 may be configured to: perform a logical operation on a plurality of paths of received input signals (including the first input signal T1 and the second input signal T2), and output the first control signal C1 by using the output end of the logical operation circuit 022. In addition, the logical operation circuit 022 can output the first control signal C1 of a valid level when any input signal received by the logical operation circuit 022 is at a valid level, and can output the first control signal C1 of an invalid level when all input signals received by the logical operation circuit 022 each are at an invalid level.

In this embodiment of this application, default connected/disconnected states of the first end and the second end of the first switch 021 may be a connected state. Therefore, the first switch 021 can output the second input signal T2 to the second input end of the logical operation circuit 022 based on the second level signal S2 output by the first controlled unit 03. Alternatively, it may be understood as that the first switch 021 can transmit the second level signal S2 to the second input end of the logical operation circuit 022, so that the second level signal S2 serves as the second input signal T2. After the first control unit 01 is faulty or abnormally powered off, if the first controlled unit 03 needs to be enabled to exit the target working state, each of the first end and the second end of the first switch 021 may be controlled to be disconnected. In this case, because the first switch 021 cannot output the second input signal T2 to the second input end of the logical operation circuit 022, and the first control unit 01 cannot continue to output the first level signal S1 (namely, the first input signal T1) of the valid level because of being faulty, being abnormally powered off, or the like, the first control signal C1 output by the logical operation circuit 022 is at an invalid level. Correspondingly, the first controlled unit 03 may exit the target working state. In other words, a state of the first controlled unit 03 may be unlocked by disconnecting each of the first end and the second end of the first switch 021.

In a first optional implementation, the valid level of the first control signal C1 may be a high level relative to the invalid level, and both valid levels of the first level signal S1 and the second level signal S2 may be high levels. Correspondingly, the logical operation circuit 022 may be configured to perform an OR operation on the first input signal T1 and the second input signal T2. Based on this, when either of the first input signal T1 and the second input signal T2 is at a high level, the first control signal C1 output by the logical operation circuit 022 is at a high level, namely, a valid level. When the first input signal T1 and the second input signal T2 each are at a low level, the first control signal C1 output by the logical operation circuit 022 is at a low level, namely, an invalid level.

In this implementation, as shown in FIG. 2, the logical operation circuit 022 may be an OR gate (OR gate). Using the OR gate as the logical operation circuit 022 can ensure a simple structure and low costs of the control system. It may be understood that, in addition to the OR gate, the logical operation circuit 022 may alternatively be implemented in another logic gate combination manner, provided that it is ensured that the logical operation circuit 022 can perform an OR operation on a plurality of paths of input level signals. For example, the logical operation circuit 022 may alternatively include two serially connected NOR gates, or include a plurality of NAND gates.

In a second optional implementation, the valid level of the first control signal C1 may be a low level relative to the invalid level. The logical operation circuit 022 may be configured to perform an OR operation and a NOT operation on the first input signal T1 and the second input signal T2 in sequence. Correspondingly, when either of the first input signal T1 and the second input signal T2 is at a high level, the first control signal C1 output by the logical operation circuit 022 may be at a low level, namely, a valid level. When the first input signal T1 and the second input signal T2 each are at a low level, the first control signal C1 output by the logical operation circuit 022 may be at a high level, namely, an invalid level.

In this implementation, as shown in FIG. 3, the logical operation circuit 022 may include an OR gate and a NOT gate. Each input end of the OR gate is each input end of the logical operation circuit 022, the output end of the OR gate is connected to an input end of the NOT gate, and the output end of the NOT gate is the output end of the logical operation circuit 022.

It may be understood that, in addition to the implementation shown in FIG. 3, the logical operation circuit 022 may alternatively be implemented in another logic gate combination manner. For example, the OR gate in the logical operation circuit 022 may be replaced with two serially connected NOR gates.

In the second implementation, if both valid levels of the first input signal T1 and the second input signal T2 are also low levels, the logical operation circuit 022 may be an AND gate, or may include two serially connected NAND gates. Therefore, the logical operation circuit 022 may output the first control signal C1 of a low level when any input signal received by the logical operation circuit 022 is at a low level, and may output the first control signal C1 of a high level when input signals received by the logical operation circuit 022 each are at a high level.

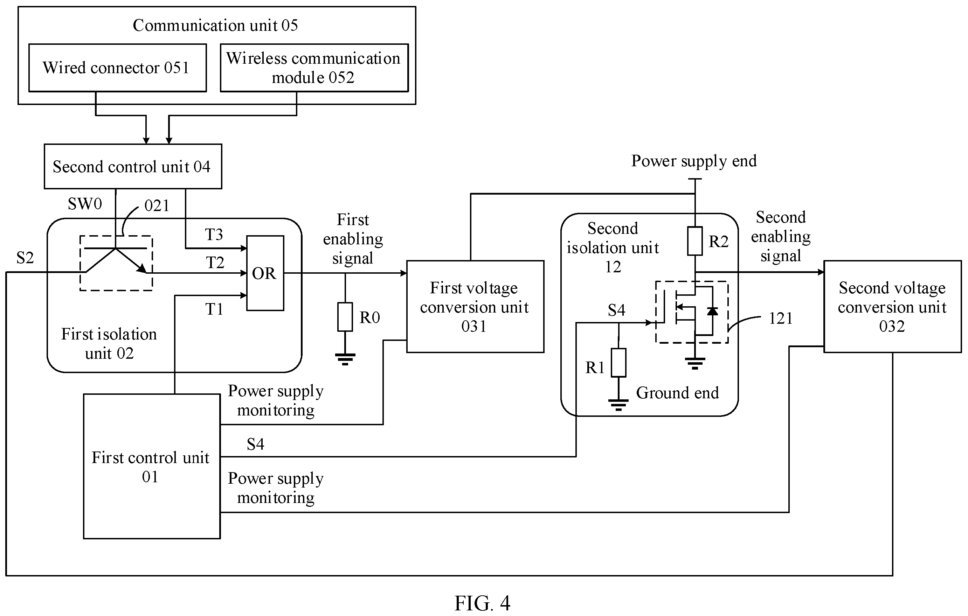

Optionally, as shown in FIG. 4, the first switch 021 may include a transistor. Alternatively, as shown in FIG. 2, the first switch 021 may include a field-effect transistor.

In an example, the transistor is an NPN transistor; a collector of the transistor may serve as the first end of the first switch 021, and is configured to receive the second level signal S2; and an emitter may serve as the second end of the first switch 021, and is connected to the second input end of the logical operation circuit 022.

In another example, the transistor is a PNP transistor; an emitter of the transistor may serve as the first end of the first switch 021, and is configured to receive the second level signal S2; and a collector may serve as the second end of the first switch 021, and is connected to the second input end of the logical operation circuit 022.

In the foregoing two examples, a base of the transistor serves as a control end, and is configured to couple a control signal, so as to conduct or cut off the transistor. For example, the base of the transistor may be coupled to an output end of another control unit (for example, a second control unit 04 described below), to obtain a control voltage, so as to control conduction or cutoff of the transistor.

In an example, as shown in FIG. 2, the field-effect transistor may be an N-type metal-oxide-semiconductor field-effect transistor (metal-oxide-semiconductor field-effect transistor, MOSFET), which is referred to as an NMOS for short. A drain of the field-effect transistor may serve as the first end of the first switch 021, and is configured to receive the second level signal S2. A source may serve as the second end of the first switch 021, and is connected to the second input end of the logical operation circuit 022.

In another example, the field-effect transistor is a PMOS transistor. A source of the field-effect transistor may serve as the first end of the first switch 021, and is configured to receive the second level signal S2. A drain may serve as the second end of the first switch 021, and is connected to the second input end of the logical operation circuit 022.

In the foregoing two examples, a gate of the field-effect transistor serves as a control end, and is configured to couple a control signal, so as to conduct or cut off the field-effect transistor. For example, the gate of the field-effect transistor may be coupled to an output end of another control unit (for example, a second control unit 04 described below), to obtain a control voltage, so as to control conduction or cutoff of the field-effect transistor.

Because structures of the transistor and the field-effect transistor are simple and costs are low, using the transistor or the field-effect transistor as the first switch 021 can effectively avoid increasing structure complexity and costs of the control system.

In this embodiment of this application, as shown in FIG. 2, the control system may further include a resistor R0. One end of the resistor R0 is connected to the output end of the logical operation circuit 022 and an input end of the first controlled unit 03, and the other end of the resistor R0 is grounded. The resistor R0 may be configured to stabilize a level of the input end of the first controlled unit 03.

Optionally, as shown in FIG. 2, the control system may further include the second control unit 04. The logical operation circuit 022 may further have a third input end. An output end of the second control unit 04 is connected to the third input end, and is configured to output a third level signal S3 to the logical operation circuit 022 as a third input signal T3 of the logical operation circuit 022.

Because the second control unit 04 can output the third level signal S3 to the logical operation circuit 022, the logical operation circuit 022 may further output the first control signal C1 to the first controlled unit 03 under an action of the third level signal S3. This effectively improves flexibility of controlling the first controlled unit 03.

It may be understood that, in a scenario in which the logical operation circuit 022 further has the third input end, the logical operation circuit 022 may perform a logical operation on the first input signal T1, the second input signal T2, and the third input signal T3 that are received. In addition, when any one of the first input signal T1, the second input signal T2, and the third input signal T3 is at a valid level, the first control signal C1 output by the logical operation circuit 022 may be at a valid level. When the first input signal T1, the second input signal T2, and the third input signal T3 each are at an invalid level, the first control signal C1 output by the logical operation circuit 022 may be at an invalid level.

In this embodiment of this application, the third level signal S3 output by the second control unit 04 after the second control unit 04 is powered on may be at an invalid level. In other words, when the first control unit 01 is normal, or when the first controlled unit 03 is in a self-locking state, the third level signal S3 does not affect a level of the first control signal C1 output by the logical operation circuit 022.

After the first control unit 01 is faulty or abnormally powered off, and the first controlled unit 03 is powered off, if a fault in the control system needs to be located, the second control unit 04 may output the third level signal S3 of a valid level. In this case, the logical operation circuit 022 may output the first control signal C1 of a valid level, and the first controlled unit 03 may be in the target working state (for example, the power-on state) under driving of the first control signal C1. This can help locate the fault in the control system.

The second control unit 04 may also be referred to as a processing unit or a management unit, and may be a component having a data processing function, a management function, and a control function. The first control unit 01 may be a component having a control function, and may control a working state of another controlled unit under control of the second control unit 04. For example, the second control unit 04 may send a power-on/off time sequence of each unit in the control system to the first control unit 01. The first control unit 01 may control, based on the power-on/off time sequence, a power-on/off state of each unit in the control system, and perform exception detection on each unit.

For example, the second control unit 04 may be a microprocessor or a micro-controller (micro-controller unit, MCU). The first control unit 01 may be a programmable logic device (programmable logic device, PLD) or another control chip having an input/output (input/output, I/O) interface. The PLD may be a complex programmable logic device (complex programmable logical device, CPLD), a field programmable gate array (field programmable gate array, FPGA), generic array logic (generic array logic, GAL), or any combination thereof.

In a scenario in which the control system further includes the second control unit 04, as shown in FIG. 2, the output end of the second control unit 04 may be connected to a third end (namely, a control end) of the first switch 021, and is configured to control connected/disconnected states of the first end and the second end of the first switch 021. For example, the second control unit 04 may output a switch signal SW0 to the third end of the first switch 021, and the first switch 021 may control the connected/disconnected states of the first end and the second end of the first switch 021 under an action of the switch signal SW0.

In this embodiment of this application, after being powered on, the second control unit 04 may first control each of the first end and the second end of the first switch 021 to be connected, so that the first switch 021 outputs the second input signal T2 to the logical operation circuit 022 based on the second level signal S2 output by the first controlled unit 03. After the first control unit 01 is faulty or abnormally powered off, if the first controlled unit 03 needs to be enabled to exit the target working state, or if a fault in the control system needs to be located, the second control unit 04 may control each of the first end and the second end of the first switch 021 to be disconnected. In this case, the first switch 021 cannot output the second input signal T2 to the logical operation circuit 022 based on the second level signal S2 output by the first controlled unit 03.

FIG. 4 is a diagram of a structure of still another control system according to an embodiment of this application. As shown in FIG. 3, the control system may further include a communication unit 05. The communication unit 05 may be connected to an input end of a second control unit 04, and is configured to output a fault detection instruction to the second control unit 04.

The second control unit 04 may control, based on the fault detection instruction, each of a first end and a second end of a first switch 021 to be disconnected, and output a third level signal S3 of a valid level to a logical operation circuit 022 in a first isolation unit 02 as a third input signal T3. In this way, the first isolation unit 02 can output a first control signal C1 of a valid level to a first controlled unit 03 based on the third input signal T3, so that the first controlled unit 03 is in a target working state.

Optionally, still refer to FIG. 3. The communication unit 05 may include a wired connector 501 and/or a wireless communication module 502. The wired connector 501 may be a vehicle-mounted connector. The wireless communication module 502 may be a Bluetooth communication module, or may be a wireless fidelity (wireless fidelity, Wi-Fi) module, or the like.

For example, control software may be installed in the second control unit 04, and the control software may control an on/off state of the first switch 021 and control a level of the third level signal S3. After a first control unit 01 is faulty or abnormally powered off, operation and maintenance personnel may upgrade the control software in the second control unit 04 by using the communication unit 05, so that the second control unit 04 controls each of the first end and the second end of the first switch 021 to be disconnected, and outputs the third level signal S3 of the valid level. For example, the operation and maintenance personnel may modify program code in a memory of the second control unit 04 by using the communication unit 05, to upgrade the control software.

In the foregoing fault locating manner, the control system does not need to be dismantled, and remote fault locating can be implemented by using the wireless communication module. Therefore, flexibility and convenience of fault locating are effectively improved.

A control unit (for example, the first control unit 01) and a controlled unit (for example, the first controlled unit 03) may belong to different domains (or subsystems), for example, a first domain (or subsystem) and a second domain (or subsystem). The second domain is used to perform redundancy backup for some or all functions of the first domain, so as to improve product reliability. The control unit controls both a function in the first domain and a backup function in the second domain. In this case, the controlled unit is a functional unit, for example, a computing unit or a processing unit. Alternatively, the control unit controls both a function in the first domain and a backup function in the second domain to be powered on. In this case, the controlled unit is a power supply unit. In this way, when a domain (for example, the first domain) in which the control unit is located is faulty, using the control system including the foregoing isolation unit can isolate impact on the second domain, so that the second domain normally works, and stability of a redundant system is improved.

For example, the first domain is a first power domain, and the second domain is a second power domain.

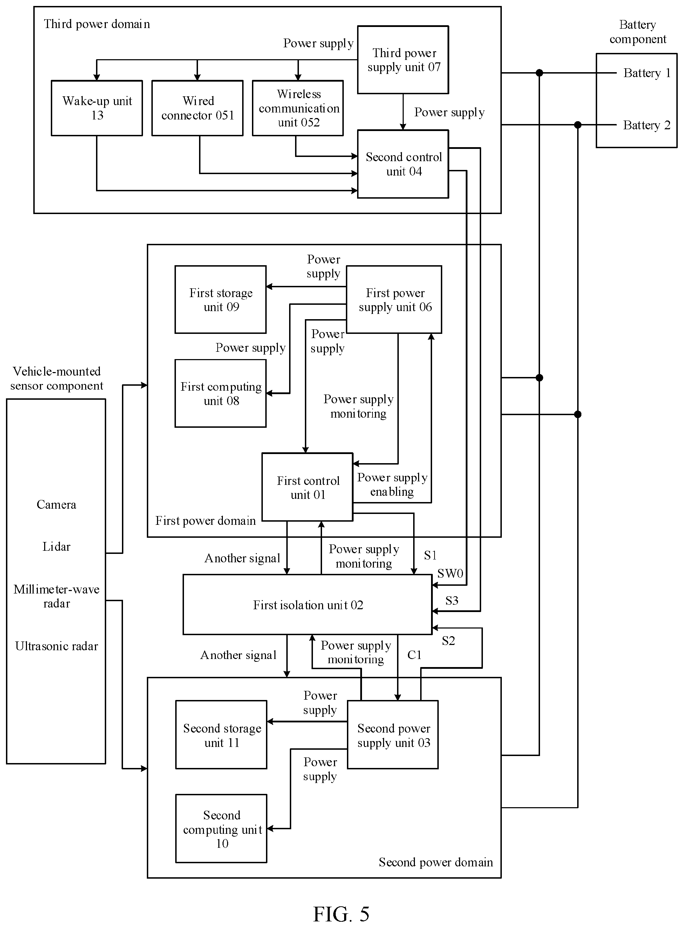

FIG. 5 is a diagram of a structure of yet another control system according to an embodiment of this application. As shown in FIG. 5, the control system includes a first power domain and a second power domain. A first control unit 01 belongs to the first power domain, and may be supplied with power by a power supply unit (namely, a first power supply unit 06 shown in FIG. 5) in the first power domain.

A first controlled unit 03 may be a power supply unit (namely, a second power supply unit 03) of the second power domain, and a first control signal C1 may be a first enabling signal used to control the second power supply unit 03 to be powered on or powered off.

In this embodiment of this application, the first power domain may further include one or more of a second control unit 04, a first computing unit 08, and a first storage unit 09. The first power supply unit 06 of the first power domain is further configured to supply power to the one or more of the second control unit 04, the first computing unit 08, and the first storage unit 09.

In a first possible implementation, as shown in FIG. 5, the first power domain further includes the first computing unit 08 and the first storage unit 09, and the first power supply unit 06 is further configured to supply power to the first computing unit 08 and the first storage unit 09. In addition, the control system further includes a third power domain. The second control unit 04 belongs to the third power domain, and may be supplied with power by a power supply unit (namely, a third power supply unit 07 shown in FIG. 5) of the third power domain. In other words, in the first implementation, the first control unit 01 and the second control unit 04 belong to different power domains, and are supplied with power by two different power supply units.

In the first implementation, as shown in FIG. 5, the communication unit 05 may also belong to the third power domain. Correspondingly, the third power supply unit 07 may be further configured to supply power to the communication unit 05. It may be understood that, when either of the first power supply unit 06 and the third power supply unit 07 is faulty, the faulty power supply unit cannot supply power to another functional unit of a power domain to which the faulty power supply unit belongs, and consequently, the another functional unit is abnormally powered off. In the first implementation, the first control unit 01 and the second control unit 04 are supplied with power by the two different power supply units. Therefore, a case in which the two control units are abnormally powered off at the same time because a specific power supply unit is faulty can be avoided.

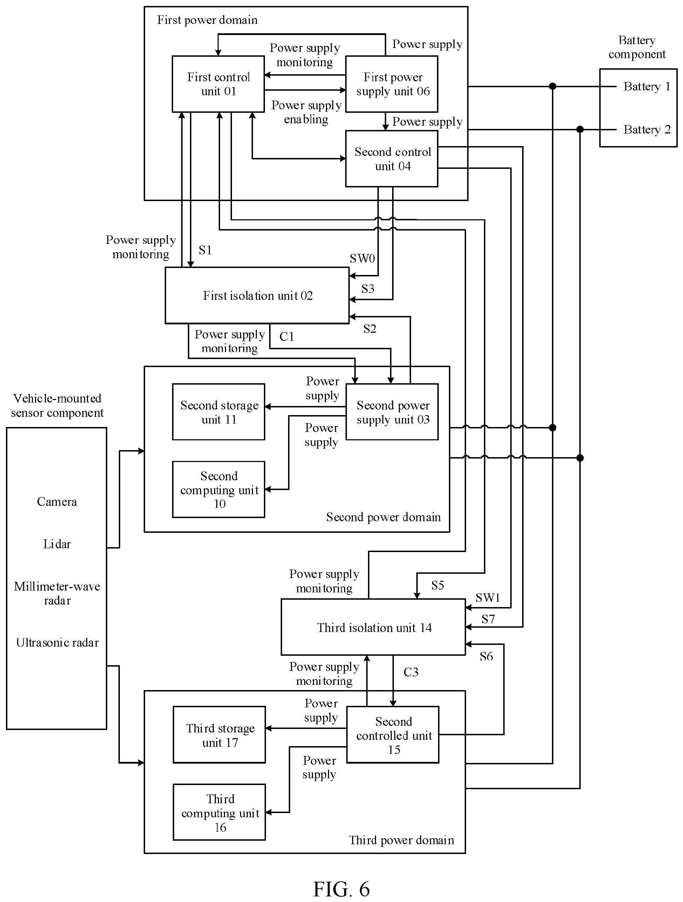

In a second possible implementation, as shown in FIG. 6, the first power supply unit 06 of the first power domain is further configured to supply power to the second control unit 04. In other words, both the first control unit 01 and the second control unit 04 may belong to the first power domain.

Refer to FIG. 6. It can be learned that, in the second implementation, the first power domain to which the first control unit 01 and the second control unit 04 belong may not include a computing unit or a storage unit. In other words, the two control units in the control system may be deployed in an independent power domain, and may perform unified management and control on a computing unit and a storage unit of another power domain.

Optionally, as shown in FIG. 5 and FIG. 6, the second power domain may further include a second computing unit 10 and/or a second storage unit 11. For example, as shown in FIG. 5 and FIG. 6, the second power domain includes the second computing unit 10 and the second storage unit 11. The second power supply unit 03 (namely, the first controlled unit 03) of the second power domain may be further configured to supply power to the second computing unit 10 and/or the second storage unit 11.

It may be understood that, when the first enabling signal output by the first isolation unit 02 is at a valid level, the second power supply unit 03 is powered on, and supplies power to another functional unit (for example, the second computing unit 10 and the second storage unit 11) of the second power domain, so that each functional unit of the second power domain can be in a working state. When the first enabling signal output by the first isolation unit 02 is at an invalid level, the second power supply unit 03 is powered off, and all functional units of the second power domain are also powered off.

It may be further understood that, in addition to the functional units shown in FIG. 5 and FIG. 6, the first power domain, the second power domain, and the third power domain may further include other functional units. In addition, the first power supply unit 06 may supply power to each functional unit of the first power domain, the second power supply unit 03 may supply power to each functional unit of the second power domain, and the third power supply unit 07 may supply power to each functional unit of the third power domain.

It may be further understood that each storage unit in the control system may be configured to store data, and each computing unit may be configured to process the data stored in the storage unit. For example, assuming that the control system is an autonomous driving module in a vehicle, the storage unit may be configured to store data collected by a vehicle-mounted sensor component, and the computing unit may be configured to process, based on a stored autonomous driving example, the data collected by the vehicle-mounted sensor component. Each power supply unit in the control system is configured to provide a direct current voltage for each functional unit of a power domain to which the power supply unit belongs, and therefore may also be referred to as a direct current power supply.

In a first possible example, a plurality of power domains in the control system may have a same function, and may back up each other. Based on this, after any power domain encounters a power failure, or a storage unit and/or a computing unit of any power domain are/is faulty, a storage unit and a computing unit of another power domain may continue to normally work. This effectively improves reliability of the control system.

In a second possible example, a plurality of power domains in the control system may have different functions. At least one power domain may be a primary power domain, and a storage unit and a computing unit of the primary power domain may implement main functions of the control system. Another power domain may be an auxiliary power domain, and a storage unit and a computing unit of the auxiliary power domain may implement auxiliary functions of the control system. For example, assuming that the control system is an autonomous driving module in a vehicle, the computing unit and the storage unit of the primary power domain may implement main autonomous driving functions, and the computing unit and the storage unit of the auxiliary power domain may implement auxiliary functions such as parking on a side and parking on a lane.

In the second possible example, if the first control unit 01 and the second control unit 04 belong to different power domains, the first control unit 01 may belong to the primary power domain (for example, the first power domain shown in FIG. 5). Correspondingly, the first isolation unit 02 may implement fault isolation between the primary power domain and the auxiliary power domain (for example, the second power domain shown in FIG. 5). Therefore, after the first control unit 01 is faulty or is abnormally powered off, the auxiliary power domain can still implement an auxiliary function (for example, may implement a function of parking on a side) of the control system, to avoid a safety risk caused when the control system is completely out of control.

It may be understood that, after the auxiliary power domain completes the auxiliary function, the second control unit 04 may control the first switch 021 in the first isolation unit 02 to be turned off, so that the auxiliary power domain is powered off. In addition, the second control unit 04 may further control a power supply unit of another power domain to be powered off, so that the control system is powered off.

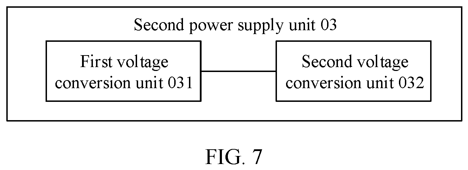

FIG. 7 is a diagram of a structure of a second power supply unit according to an embodiment of this application. As shown in FIG. 7, the second power supply unit 03 may include a first voltage conversion unit 031 and a second voltage conversion unit 032. The first voltage conversion unit 031 may be connected to a battery component, and can convert a voltage of the battery component and output the converted voltage. The second voltage conversion unit 032 can convert a voltage output by the first voltage conversion unit 031 and output the converted voltage. Therefore, the two voltage conversion units can provide different drive voltages for functional units in the second power domain. For example, assuming that a drive voltage required by the second computing unit 10 of the second power domain is different from a drive voltage required by the second storage unit 11, the second computing unit 10 and the second storage unit 11 may be driven by different voltage conversion units of the second power supply unit 03.

As shown in FIG. 4, the control system may further include a second isolation unit 12. The first isolation unit 02 is configured to output the first control signal C1 (namely, the first enabling signal) to the first voltage conversion unit 031 of the second power supply unit 03. The first enabling signal may be used to control the first voltage conversion unit 031 to be powered on or powered off.

The first control unit 01 may be further connected to the second isolation unit 12, and is configured to output a fourth level signal S4 to the second isolation unit 12. The second isolation unit 12 has an input end and an output end. The second isolation unit 12 is configured to receive the fourth level signal S4 by using the input end of the second isolation unit 12, and output, under an action of the fourth level signal S4, a second control signal (which may also be referred to as a second enabling signal) to the second voltage conversion unit 032 by using the output end of the second isolation unit 12. The second enabling signal may be used to control the second voltage conversion unit 032 to be powered on or powered off.

In this embodiment of this application, if the fourth level signal S4 output by the first control unit 01 is at an invalid level, the second enabling signal output by the second isolation unit 12 may be at a valid level. Correspondingly, the second voltage conversion unit 032 is in a power-on state. If the fourth level signal S4 is at a valid level, the second enabling signal output by the second isolation unit 12 may be at an invalid level. Correspondingly, the second voltage conversion unit 032 is in a power-off state. The valid level of the fourth level signal S4 may be a high level relative to the invalid level.

When the first control unit 01 is faulty or is abnormally powered off, the first control unit 01 cannot output the fourth level signal S4 of the valid level. Therefore, the input end of the second isolation unit 12 remains at an invalid level. In this case, the second isolation unit 12 can continue to output the second enabling signal of the valid level to the second voltage conversion unit 032, so that the second voltage conversion unit 032 continues to remain in a power-on state. Therefore, impact of a fault or abnormal power-off of the first control unit 01 on the power-on state of the second voltage conversion unit 032 can be avoided, that is, fault isolation between the first control unit 01 and the second voltage conversion unit 032 can be implemented.

For example, after being powered on, the first control unit 01 may output the first control signal C1 of the valid level, and output the fourth level signal S4 of the valid level. The second isolation unit 12 can output the second enabling signal of the invalid level under an action of the fourth level signal S4 of the valid level, so that the second voltage conversion unit 032 remains in a power-off state. The first isolation unit 02 can output, under an action of the first control signal C1 of the valid level, the first enabling signal of the valid level to the first voltage conversion unit 031, to drive the first voltage conversion unit 031 to be powered on.

As shown in FIG. 4, the first control unit 01 can further perform power supply monitoring on the first voltage conversion unit 031, and may output the fourth level signal S4 of the invalid level to the second isolation unit 12 after detecting that power-on of the first voltage conversion unit 031 is completed (power good). The second isolation unit 12 can output the second enabling signal of the valid level under an action of the fourth level signal S4 of the invalid level, to drive the second voltage conversion unit 032 to be powered on.

Optionally, as shown in FIG. 4, the second isolation unit 12 may include a second switch 121. The second switch 121 has a first end, a second end, and a third end. The first end of the second switch 121 serves as the input end of the second isolation unit 12, and is configured to receive the fourth level signal S4. The fourth level signal S4 is used to control connected/disconnected states of the second end and the third end of the second switch 121. The second end of the second switch 121 serves as the output end of the second isolation unit 12 and is connected to a power supply end and an input end of the second voltage conversion unit 032. The third end of the second switch 121 is connected to a ground end.

The power supply end may be an output end of the first voltage conversion unit 031. When the fourth level signal S4 is at a valid level, each of the second end and the third end of the second switch 121 is connected. In this case, because both the power supply end and the input end of the second voltage conversion unit 032 are connected to the ground end, the second voltage conversion unit 032 is in a power-off state. When the fourth level signal S4 is at an invalid level, each of the second end and the third end of the second switch 121 is disconnected. In this case, because the input end of the second voltage conversion unit 032 is connected to the power supply end, the second voltage conversion unit 032 can remain in a power-on state under driving of the power supply end.

If the first control unit 01 encounters a fault or an abnormal power failure, the fourth level signal S4 received by the first end of the second switch 121 may remain at an invalid level. Correspondingly, the second end and the third end of the second switch 121 may remain in a disconnected state, to ensure that the second voltage conversion unit 032 can remain in a power-on state under driving of the power supply end.

In an example, as shown in FIG. 4, the second switch 121 may include a field-effect transistor, and the field-effect transistor may be an NMOS. A gate of the field-effect transistor may serve as the first end (namely, a control end) of the second switch 121, and is configured to receive the fourth level signal S4. A drain of the field-effect transistor may serve as the second end of the second switch 121, and is separately connected to the power supply end and the input end of the second voltage conversion unit 032. A source of the field-effect transistor may serve as the third end of the second switch 121 and connected to the ground end.

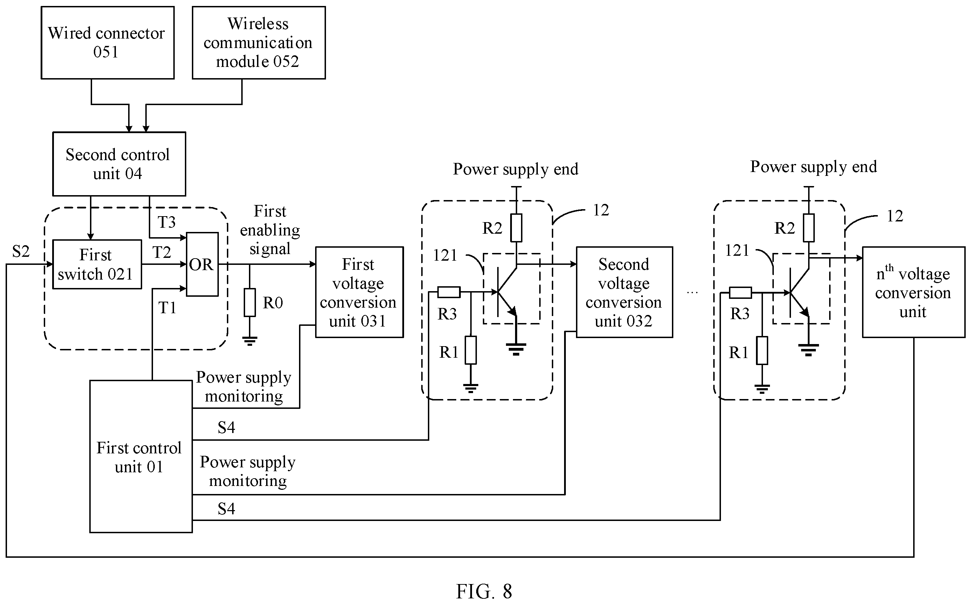

In another example, as shown in FIG. 8, the second switch 121 may include a transistor, and the transistor may be an NPN transistor. A base of the transistor may serve as the first end of the second switch 121, and is configured to receive the fourth level signal S4. A collector of the transistor may serve as the second end of the second switch 121, and is separately connected to the power supply end and the input end of the second voltage conversion unit 032. An emitter of the transistor may serve as the third end of the second switch 121 and connected to the ground end.

Optionally, the field-effect transistor in the second switch 121 may be a PMOS, and the transistor in the second switch 121 may be a PNP transistor. This is not limited in this embodiment of this application.

It can be seen from FIG. 4 and FIG. 8 that, the second isolation unit 12 may further include a first resistor R1 and a second resistor R2. One end of the first resistor R1 is connected to the first end of the second switch 121, the other end of the first resistor R1 is connected to the ground end, and the first resistor R1 is configured to stabilize a level of the first end of the second switch 121. The second resistor R2 is connected in series between the power supply end and the second end of the second switch 121, that is, the second end of the second switch 121 is connected to the power supply end by using the second resistor R2. The second resistor R2 is a pull-up resistor, and is configured to pull up a level of the second end of the second switch 121.

Still refer to FIG. 8. The second isolation unit 12 may further include a third resistor R3, and the third resistor R3 is connected in series between the output end of the first control unit 01 and the first end of the second switch 121. The third resistor R3 may be configured to control a current at the first end of the second switch 121, for example, control a base current of the transistor. The third resistor R3 and the first resistor R1 may further form a voltage division circuit, to adjust the level of the first end of the second switch 121.

A connection manner of the field-effect transistor in the second isolation unit 12 shown in FIG. 4 may also be referred to as an open drain (open drain, OD) output structure, and a connection manner of the transistor in the second isolation unit 12 shown in FIG. 8 may also be referred to as an open collector (open collector, OC) output structure. Fault isolation of the first control unit 01 may be implemented based on the OD output structure or the OC output structure.

The foregoing is described by using an example in which the second power supply unit 03 includes two voltage conversion units. It may be understood that a quantity of voltage conversion units included in the second power supply unit 03 may be further greater than 2. As shown in FIG. 8, the second power supply unit 03 may include n cascaded voltage conversion units, where n is an integer greater than 1. The first voltage conversion unit (namely, the first voltage conversion unit 031) in the n voltage conversion units may be connected to the battery component, and can convert a voltage provided by the battery component and output the converted voltage. Each of the second to the n^{th} voltage conversion units may be configured to convert a voltage output by a previous-stage voltage conversion unit or several previous-stage voltage conversion units, and then output the converted voltage.

In addition, refer to FIG. 8. The control system may include a plurality of second isolation units 12 that are in a one-to-one correspondence with the second to the n^{th} voltage conversion units. Each second isolation unit 12 is connected to a corresponding voltage conversion unit, and is configured to output a second enabling signal to the corresponding voltage conversion unit under an action of the fourth level signal S4 provided by the first control unit 01. It may be understood that a power supply end connected to each second isolation unit 12 in FIG. 8 may be an output end of a previous-stage voltage conversion unit or several previous-stage voltage conversion units.

For example, after detecting that power-on of any voltage conversion unit is completed, the first control unit 01 may output the fourth level signal S4 of the invalid level to a second isolation unit 12 corresponding to a next voltage conversion unit, so that the next voltage conversion unit is powered on. Therefore, the n cascaded voltage conversion units in the second power supply unit 03 may be sequentially powered on.

It may be further understood that, in a scenario in which the second power supply unit 03 includes the n voltage conversion units, the second level signal S2 may be output after power-on of any one of the n voltage conversion units is completed.

In this embodiment of this application, the control system may have a plurality of different working modes. The first control unit 01 may be configured to output the first level signal S1 and the fourth level signal S4 based on a working mode of the control system. The working modes of the control system may include a normal working mode, a sleep mode, a shallow sleep mode, and the like.

It can be learned from the foregoing analysis that, a power-on/off state of each voltage conversion unit in the second power supply unit 03 can be controlled by controlling levels of the first level signal S1 and the fourth level signal S4. Therefore, when the control system is in different working modes, the first control unit 01 may control different voltage conversion units in the second power supply unit 03 to be powered on, so that power consumption of the control system can be effectively reduced without affecting performance of the control system.

In the normal working mode, the first control unit 01 may output the first level signal S1 of the valid level, and may output the fourth level signal S4 of the invalid level after it is detected that power-on the first voltage conversion unit 031 is completed. Therefore, each voltage conversion unit in the second power supply unit 03 can be normally powered on, so that each functional unit (for example, the second computing unit 10 and the second storage unit 11) of the second power domain to which the second power supply unit 03 belongs can normally work.

In the sleep mode, the first level signal S1 output by the first control unit 01 may be at an invalid level, so that the first voltage conversion unit 031 in the second power supply unit 03 can remain in a power-off state. Because the first voltage conversion unit 031 is in the power-off state, another voltage conversion unit in the second power supply unit 03 also remains in a power-off state. In this case, each functional unit of the second power domain to which the second power supply unit 03 belongs is in a power-off state.

In the shallow sleep mode, the first level signal S1 output by the first control unit 01 may be at a valid level, and the fourth level signal S4 may be at a valid level. In this way, the first voltage conversion unit 031 in the second power supply unit 03 can remain in a power-on state, and the second voltage conversion unit 032 in the second power supply unit 03 can remain in a power-off state. In this case, in the second power domain to which the second power supply unit 03 belongs, a functional unit (for example, the second storage unit 11) driven by the first voltage conversion unit 031 may remain in a working state, and a functional unit (for example, the second computing unit 10) driven by the second voltage conversion unit 032 may be in a power-off state.

It may be understood that, if the quantity of voltage conversion units included in the second power supply unit 03 is greater than 2, in the shallow sleep mode, the first control unit 01 may control, based on a requirement of an application scenario, some voltage conversion units in the plurality of voltage conversion units to be powered on, and control the other voltage conversion units to be powered off. Therefore, only some functional units of the second power domain to which the second power supply unit 03 belongs can be enabled to be in a working state.

It may be further understood that, in the normal working mode, each power domain of the control system may be in a power-on state. For example, refer to FIG. 5. The first power supply unit 06, the second power supply unit 03, and the third power supply unit 07 are all in a power-on state, and correspondingly, each functional unit of the first power domain, the second power domain, and the third power domain is in a normal working state.

Still refer to FIG. 5. The third power domain to which the second control unit 04 belongs may further include a wake-up unit 13. The wake-up unit 13 may be a controller local area network (controller area network, CAN) wake-up module. In the sleep mode, only the wake-up unit 13 may be in a power-on state, and other functional units in the control system may be in a power-off state. Correspondingly, in the sleep mode, only a voltage conversion unit that is in the third power supply unit 07 and that is configured to drive the wake-up unit 13 is powered on, and other voltage conversion units in the third power supply unit 07, the first power supply unit 06, and the second power supply unit 03 may all remain in a power-off state.

In the light sleep mode, the wake-up unit 13, the first control unit 01, and the storage unit of each power domain may all be in a power-on state, and other functional units may all be in a power-off state. Correspondingly, in the shallow sleep mode, a voltage conversion unit that is in the third power supply unit 07 and that is configured to drive the wake-up unit 13 may be controlled to be powered on, a voltage conversion unit that is in the first power supply unit 06 and that is configured to drive the first control unit 01 may be controlled to be powered on, and a voltage conversion unit that is in each power supply unit and that is configured to drive the storage unit may be controlled to be powered on.

The foregoing is described by using an example in which the first controlled unit 03 is the second power supply unit of the second power domain. In a possible example, the first controlled unit 03 may alternatively be a computing unit, and the first control signal C1 may be a reset signal used to control reset of the computing unit. The computing unit and the first control unit 01 may belong to a same power domain, or may belong to different power domains.

For example, refer to FIG. 5. The first controlled unit 03 may be the first computing unit 08 that belongs to the same first power domain as the first control unit 01. Alternatively, refer to FIG. 5 and FIG. 6. The first controlled unit 03 may be the second computing unit 10 of the second power domain.

Optionally, as shown in FIG. 6, the control system may further include a third isolation unit 14 and a second controlled unit 15. The first control unit 01 may be further connected to the third isolation unit 14, and is configured to output a fifth level signal S5 to the third isolation unit 14.

The third isolation unit 14 has a first input end, a second input end, and an output end, and the third isolation unit 14 is configured to: receive the fifth level signal S5 and a sixth level signal S6 by using the first input end and the second input end of the third isolation unit 14 respectively, and output a third control signal C3 to the second controlled unit 15 by using the output end of the third isolation unit 14.

The second controlled unit 15 is configured to output the sixth level signal S6 to the second input end of the third isolation unit 14 under an action of the third control signal C3.

A structure and a working principle of the third isolation unit 14 may be the same as those of the first isolation unit 02, and details are not described herein again. In addition, it can be learned from FIG. 6 that the second control unit 04 may also be connected to the third isolation unit 14, and may output a seventh level signal S7 to a logical operation circuit in the third isolation unit 14, and output a switch signal SW1 to a first switch in the third isolation unit 14. The switch signal SW1 can control connected/disconnected states of a first end and a second end of the first switch in the third isolation unit 14.

It may be understood that the second controlled unit 15 and the first controlled unit 03 may belong to different power domains. For example, refer to FIG. 6. The first controlled unit 03 (namely, the second power supply unit 03) belongs to the second power domain, and the second controlled unit 15 belongs to the third power domain. Alternatively, the two controlled units may belong to a same power domain. This is not limited in this embodiment of this application.

Optionally, as shown in FIG. 6, the second controlled unit 15 may be a power supply unit of the third power domain, and the third power domain may further include a third computing unit 16 and/or a third storage unit 17. The second controlled unit 15 may be configured to supply power to the third computing unit 16 and/or the third storage unit 17.

If the power supply unit of the third power domain also includes a plurality of cascaded voltage conversion units, the control system may further include at least one fourth isolation unit, and each fourth isolation unit is configured to implement fault isolation between the first control unit 01 and one voltage conversion unit. A structure and a working principle of the fourth isolation unit may be the same as those of the second isolation unit 12 described above, and details are not described herein again.

It may be further understood that a quantity of controlled units included in the control system may be greater than 2. In addition, for each controlled unit, a corresponding isolation unit is configured in the control system, to implement fault isolation for the first control unit 01. For a structure and a working principle of an isolation unit corresponding to each controlled unit, refer to the first isolation unit 02. Details are not described in this embodiment of this application again.

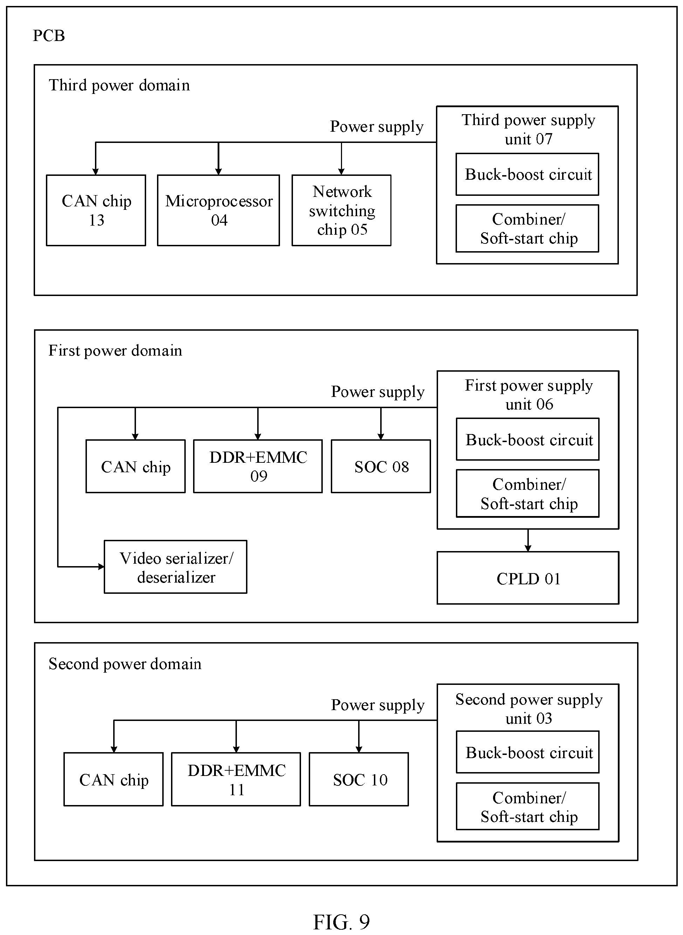

FIG. 9 is a diagram of a structure of a still further control system according to an embodiment of this application. As shown in FIG. 9, units in the control system may be integrated on a board, for example, may be integrated on a printed circuit board (printed circuit board, PCB). In other words, the control system provided in this embodiment of this application may be a board.

Refer to FIG. 9. Each power supply unit in the control system may include a buck-boost (buck-boost) circuit. For example, the voltage conversion unit described above may include the buck-boost circuit. In addition, each power supply unit may further include a combiner chip configured to combine voltages provided by a plurality of batteries in a battery component, and a soft-start chip configured to implement soft-start.

Still refer to FIG. 9. The communication unit 05 of the third power domain to which the second control unit 04 belongs may be a network switching chip, the second control unit 04 may be a microprocessor, and the wake-up unit 13 may be a CAN chip. The first control unit 01 may be a CPLD. Computing units (for example, the first computing unit 08 and the second computing unit 10) of each power domain may be all systems on chip (system on chip, SOCs), and each of storage units (for example, the first storage unit 09 and the second storage unit 11) may include a double data rate synchronous dynamic random access memory (double data rate synchronous dynamic random access memory, DDR SDRAM), an embedded multi media card (embedded multi media card, EMMC), and the like.

Optionally, as shown in FIG. 9, each of the first power domain and the second power domain may also include a CAN chip. In addition, the first power domain may further include a video serializer/deserializer.

In conclusion, embodiments of this application provide the control system. The first isolation unit in the control system can receive the first level signal output by the first control unit and the second level signal output by the first controlled unit, and can output the first control signal to the first controlled unit. The first controlled unit can output the second level signal to the first isolation unit under an action of the first control signal. Based on this, even if the first control unit is faulty, the first isolation unit can continue to output the first control signal to the first controlled unit based on the second level signal output by the first controlled unit. In this way, this implements isolation of the fault of the first control unit, that is, implements decoupling the first control unit from the first controlled unit, thereby effectively improving reliability of the control system.

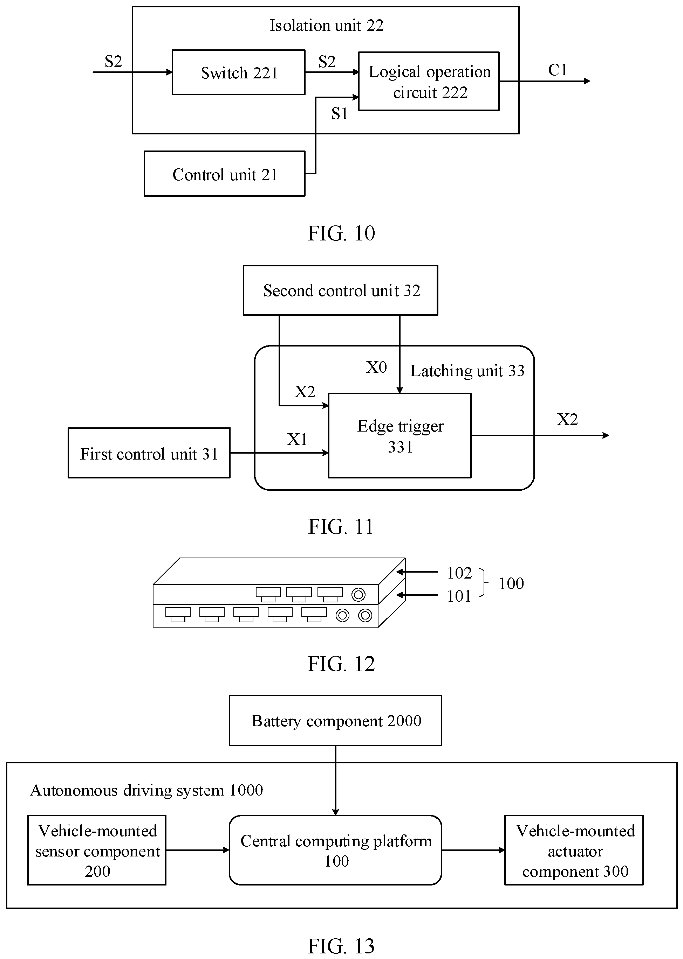

An embodiment of this application further provides a control apparatus. As shown in FIG. 10, the control apparatus includes a control unit 21 and an isolation unit 22. The control unit 21 is connected to the isolation unit 22, and is configured to output a first level signal S1 to the isolation unit 22.

The isolation unit 22 has a first input end, a second input end, and an output end, and the isolation unit 22 is configured to: receive the first level signal S1 by using the first input end of the isolation unit 22, receive, by using the second input end of the isolation unit 22, a second level signal S2 output by the controlled unit (not shown in FIG. 10), and output a first control signal C1 to a controlled unit by using the output end. The first control signal C1 is used to control a controlled unit to output the second level signal S2.

For a structure and a working principle of the control unit 21, refer to the foregoing related description of the first control unit 01. For a structure and a working principle of the isolation unit 22, refer to the foregoing related description of the first isolation unit 02. Details are not described in this embodiment of this application again.

It may be understood that, in the control system provided in the foregoing embodiment, the first isolation unit 02 and the first control unit 01 may be independent of each other. That is, the first isolation unit 02 may be a discrete device. In addition, both a second isolation unit 12 and a third isolation unit 14 in the control system may be discrete devices. In the control apparatus shown in FIG. 10, the isolation unit 22 and the control unit 21 may be integrated. For example, the isolation unit 22 and the control unit 21 may be integrated in a CPLD.

FIG. 11 is a diagram of a structure of another control apparatus according to an embodiment of this application. As shown in FIG. 11, the control apparatus includes a first control unit 31, a second control unit 32, and a latching unit 33. The first control unit 31 is connected to the latching unit 33, and is configured to output a first level signal X1 to the latching unit 33. The second control unit 32 is also connected to the latching unit 33, and is configured to output a second level signal X2 to the latching unit 33.

The latching unit 33 has a first input end, a second input end, and an output end. The latching unit 33 is configured to receive the first level signal X1 and the second level signal X2 by using the first input end and the second input end of the latching unit 33 respectively, sample and latch the second level signal X2 under an action of the first level signal X1, and output a latched signal to a controlled unit (not shown in FIG. 11) by using the output end of the latching unit 33.

The first level signal X1 output by the first control unit 31 may include at least one targeted edge change. The targeted edge change may be a rising edge jumping from a low level to a high level, or may be a falling edge jumping from a high level to a low level. A level of the second level signal X2 output by the second control unit 32 may be a valid level.

The latching unit 33 may sample and latch the level of the second level signal X2 when the first level signal X1 has a targeted edge change, and output the latched second level signal X2. When the first control unit 31 is faulty or abnormally powered off, the first level signal X1 output by the first control unit 31 does not have a targeted edge change. Therefore, the first level signal X1 does not trigger the latching unit 33 to adjust a level of a signal output by the latching unit 33, and the controlled unit may continue to remain in a previous working state. In other words, the latching unit 33 can avoid impact of the fault of the first control unit 31 on the working state of the controlled unit, thereby implementing isolation of the fault of the first control unit 31.

It may be understood that, if the targeted edge change is a falling edge jumping from a high level to a low level, when the first control unit 31 is faulty or is abnormally powered off, the first level signal X1 may remain at a low level. If the targeted edge change is a rising edge jumping from a low level to a high level, when the first control unit 31 is faulty or is abnormally powered off, the first level signal X1 may first jump from a high level to a low level (that is, a falling edge occurs on the first level signal X1), and then remain at the low level. Neither the first level signal X1 of the low level nor the falling edge of the first level signal X1 triggers the latching unit 33 to adjust the level of the signal output by the latching unit 33, that is, the latching unit 33 does not respond to the low level and the falling edge.

In this embodiment of this application, if the signal output by the latching unit 33 is at a valid level, the controlled unit may remain in a target working state under an action of the valid level. For example, the controlled unit may remain in a power-on state or a reset state. If the signal output by the latching unit 33 is at an invalid level, the controlled unit may exit the target working state. For example, the controlled unit may be in a power-off state.

Optionally, as shown in FIG. 11, the latching unit 33 may include an edge trigger 331. The edge trigger 331 may sample and latch the level (valid level) of the second level signal X2 when the first level signal X1 has a targeted edge change, and output a latched signal. For example, the edge trigger 331 may be a D trigger, an edge JK trigger, a complementary metal oxide semiconductor (complementary metal oxide semiconductor, CMOS) edge trigger, or the like.

Still refer to FIG. 11. The latching unit 33 may further have a power supply end, and the second control unit 32 is further connected to the power supply end of the latching unit 33, and is configured to output a power supply control signal X0 (which may also be referred to as an enabling signal) to the latching unit 33, so as to control a power-on/off state of the latching unit 33.

For example, after being powered on, the second control unit 32 may output the power supply control signal X0 of a valid level to the latching unit 33, so as to control the latching unit 33 to be powered on, and output the second level signal X2 of the valid level to the latching unit 33. After being powered on, the first control unit 31 may output the first level signal X1 having a targeted edge change (for example, a rising edge) to the latching unit 33. The latching unit 33 may output a signal of a valid level, so that the controlled unit remains in the target working state. After the first control unit 31 is faulty or abnormally powered off, the latching unit 33 may continuously output a signal of a valid level, and the controlled unit may continue to remain in the target working state. In this case, if the controlled unit needs to exit the target working state, the second control unit 32 may output the power supply control signal XO of an invalid level to the latching unit 33, so as to control the latching unit 33 to be powered off. Therefore, the latching unit 33 cannot continue to output a signal of a valid level, and the controlled unit may exit the target working state. For example, the controlled unit may be powered off.

It may be understood that, for structures and working principles of the first control unit 31, the second control unit 32, and the controlled unit, refer to related descriptions in the foregoing embodiment. Details are not described herein again. If the controlled unit is a power supply unit of a power domain, and the power supply unit includes a plurality of voltage conversion units, the control apparatus may further include an isolation unit, and the isolation unit can implement fault isolation between the first control unit 31 and the voltage conversion unit. For a structure and a working principle of the isolation unit, refer to related descriptions of the second isolation unit 12 in the foregoing embodiment. Details are not described herein again.

It may be further understood that the control apparatus may include a plurality of controlled units. For each controlled unit, a corresponding latching unit 33 is configured in the control apparatus, to isolate a fault of the first control unit 31.

It may be further understood that the latching unit 33 of the control apparatus may be disposed independently of the first control unit 31 and the second control unit 32, that is, the latching unit 33 may be a discrete device. Alternatively, the latching unit 33 may be integrated with the first control unit 31, for example, the latching unit 33 and the first control unit 31 may be integrated into a CPLD.

The control unit (for example, the first control unit 31) and the controlled unit may belong to different domains (or subsystems), for example, a first domain (or subsystem) and a second domain (or subsystem). The second domain is used to perform redundancy backup for some or all functions of the first domain, so as to improve product reliability. The control unit controls both a function in the first domain and a backup function in the second domain. In this case, the controlled unit is a functional unit, for example, a computing unit or a processing unit. Alternatively, the control unit controls both a function in the first domain and a backup function in the second domain to be powered on. In this case, the controlled unit is a power supply unit. In this way, when a domain (for example, the first domain) in which the control unit is located is faulty, using the control system including the foregoing isolation unit can isolate impact on the second domain, so that the second domain normally works, and stability of a redundant system is improved.

In conclusion, embodiments of this application provide the control apparatus. The latching unit in the control apparatus can sample and latch, under an action of the first level signal output by the first control unit, the second level signal output by the second control unit, and can output the latched signal to the controlled unit. Based on this, even if the first control unit is faulty, the latching unit can continue to output the latched signal to the first controlled unit. In this way, this implements isolation of the fault of the first control unit, and effectively improves reliability of the control apparatus.

An embodiment of this application further provides a control system. The control system may include the control apparatus and the controlled unit provided in the foregoing embodiment. A structure of the control apparatus may be shown in FIG. 10 or FIG. 11.

An embodiment of this application further provides a central computing platform. The central computing platform includes the control system provided in the foregoing embodiment and at least one interface. The at least one interface may include one or more of a power interface, an Ethernet interface, a sensor interface, and the like. Optionally, the central computing platform may be an intelligent central computing module (intelligent central computing model, ICCM), and the central computing platform may be a cassette device.

The central computing platform may be, for example, a high-performance central computing platform (high-performance central computer platform, HCCP). As shown in FIG. 12, the central computing platform 100 may include an intelligent central computing module 101 and an intelligent enhanced entertainment module (intelligent enhanced entertainment module, IEEM) 102.

Optionally, as shown in FIG. 12, the intelligent enhanced entertainment module 102 may also be a cassette device. Alternatively, the intelligent central computing module 101 and the intelligent enhanced entertainment module 102 may be integrated into a cassette device.

For example, the central computing platform 100 may provide an autonomous driving function. An embodiment of this application further provides an autonomous driving system. As shown in FIG. 13, the autonomous driving system 1000 may include the central computing platform 100 provided in the foregoing embodiment, a vehicle-mounted sensor component 200, and a vehicle-mounted actuator component 300. The central computing platform 100 is configured to: process data collected by the vehicle-mounted sensor component 200, and control the vehicle-mounted actuator component 300 to perform an autonomous driving operation. For example, the autonomous driving system 1000 may implement an autonomous driving function at any one of a level 2 (level 2, L2) to a level 5 (level 5, L5).

Optionally, refer to FIG. 5 and FIG. 6. The vehicle-mounted sensor component 200 may include at least one of the following sensors: a camera, a lidar, a millimeter-wave radar, an ultrasonic radar, and the like. The vehicle-mounted actuator component 300 may include at least one of the following components: an acceleration pedal, a brake pedal, a steering system, a motor, a valve, a switch, a relay, and the like.

To improve security and reliability of an autonomous driving system in a vehicle, the autonomous driving system is generally implemented in a manner of multiple control domains (also referred to as power domains). In addition, the control domains in the autonomous driving system are independent of each other. After any control domain encounters a fault or a power failure, normal operation of another control domain is not affected. Each control domain may include a power supply unit, a storage unit, a computing unit, a control unit, and a processing unit. However, although the foregoing implementation of the multiple control domains has high reliability, a structure is complex, a size is large, and costs are high.

In this embodiment of this application, it can be learned from FIG. 5 and FIG. 6 that, in the control system of the autonomous driving system, at least two domains may be controlled by using one control unit, for example, the first control unit 01. In this way, costs are reduced, and product reliability is not affected. For example, the first control unit 01 and/or the second control unit 04 may uniformly control controlled units in the plurality of power domains, that is, the power domains may share one first control unit 01 and/or one second control unit 04. Therefore, deployment of the control units can be reduced, and a size, structure complexity, and costs of the control system can be effectively reduced.

In addition, because the control system provided in this embodiment of this application further includes an isolation unit or a latching unit, a fault of the first control unit may be isolated from the controlled unit, thereby effectively ensuring reliability of the control system during working.

An embodiment of this application further provides a carrier. The carrier may include the control system provided in the foregoing embodiment, for example, may include the autonomous driving system 1000 shown in FIG. 13. The carrier may include a road transportation means, a water transportation means, an air transportation means, an industrial device, an agricultural device, an entertainment device, or the like. For example, the carrier may be a vehicle. The vehicle is a vehicle in a broad sense, and may be a transportation means (for example, a commercial vehicle, a passenger vehicle, a motorcycle, a flight vehicle, or a train), an industrial vehicle (for example, a forklift, a trailer, or a tractor), an engineering vehicle (for example, an excavator, a bulldozer, or a crane), an agricultural device (for example, a lawn mower or a harvester), a recreation device, a toy vehicle, or the like. A type of the vehicle is not specifically limited in this embodiment of this application. For another example, the carrier may be an aircraft, a ship, or another transportation means.

Optionally, as shown in FIG. 5, FIG. 6, and FIG. 13, the carrier may further include a battery component 2000, and the battery component 2000 is configured to power a power supply unit in the control system.

Optionally, as shown in FIG. 5 and FIG. 6, the battery component 2000 may include a plurality of batteries. For example, FIG. 5 and FIG. 6 show two batteries in total: a battery 1 and a battery 2. The plurality of batteries may all be configured to supply power to each power supply unit in the control system. By way of disposing plurality of batteries, it can be ensured that after any battery is faulty, another battery can continue to supply power to the control system, thereby effectively improving reliability.

The term "at least one" in this application means one or more, and the term "a plurality of" in this application means two or more. The "and/or" mentioned in this specification indicates that three relationships may exist. For example, A and/or B may represent the following three cases: Only A exists, both A and B exist, and only B exists. The character "/" generally indicates an "or" relationship between the associated objects.

The foregoing descriptions are merely implementations of this application, but are not intended to limit the protection scope of this application. Any modification or replacement readily figured out by a person skilled in the art within the technical scope disclosed in this application shall fall within the protection scope of this application. Therefore, the protection scope of this application shall be subject to the protection scope of the claims.

## Claims

1. A control system, comprising a first control unit, a first isolation unit, and a first controlled unit, wherein
the first control unit is connected to the first isolation unit, and is configured to output a first level signal to the first isolation unit;
the first isolation unit has a first input end, a second input end, and an output end, and the first isolation unit is configured to: receive the first level signal and a second level signal by using the first input end and the second input end respectively, and output a first control signal to the first controlled unit by using the output end; and
the first controlled unit is configured to output the second level signal to the second input end of the first isolation unit under an action of the first control signal.

2. The control system according to claim 1, wherein the first isolation unit comprises a first switch and a logical operation circuit, the first switch has a first end and a second end, and the logical operation circuit has a first input end, a second input end, and an output end;
the first input end of the logical operation circuit serves as the first input end of the first isolation unit, and is configured to receive the first level signal as a first input signal;
the first end of the first switch serves as the second input end of the first isolation unit, and is configured to receive the second level signal; and the second end of the first switch is connected to the second input end of the logical operation circuit, and is configured to output a second input signal to the second input end of the logical operation circuit when the first switch is turned on; and
the logical operation circuit is configured to: perform a logical operation on the first input signal and the second input signal, and output the first control signal by using the output end.

3. The control system according to claim 2, wherein the logical operation circuit is configured to perform an OR operation on the first input signal and the second input signal.

4. The control system according to claim 3, wherein the logical operation circuit is an OR gate.

5. The control system according to any one of claims 2 to 4, wherein the first switch comprises a transistor or a field-effect transistor.

6. The control system according to any one of claims 2 to 5, further comprising a second control unit, wherein
the logical operation circuit further has a third input end; and an output end of the second control unit is connected to the third input end, and is configured to output a third level signal to the logical operation circuit as a third input signal of the logical operation circuit.

7. The control system according to any one of claims 2 to 5, further comprising a second control unit, wherein
the first switch further has a third end; and an output end of the second control unit is connected to the third end of the first switch, and is configured to control connected/disconnected states of the first end and the second end of the first switch.

8. The control system according to claim 6 or 7, further comprising a communication unit, wherein
the communication unit is connected to an input end of the second control unit, and is configured to output a fault detection instruction to the second control unit.

9. The control system according to any one of claims 1 to 8, wherein the control system comprises a first domain and a second domain, the second domain is used to perform redundancy backup for some or all functions of the first domain, the first control unit belongs to the first domain, and the first controlled unit belongs to the second domain.

10. The control system according to any one of claims 1 to 9, wherein the control system comprises a first power domain and a second power domain, and the first control unit belongs to the first power domain; and
the first controlled unit is a power supply unit of the second power domain, and the first control signal is used to control the power supply unit of the second power domain to be powered on or powered off.

11. The control system according to claim 10, wherein the first control unit is supplied with power by a power supply unit of the first power domain.

12. The system according to claim 11, wherein the first power domain further comprises one or more of the second control unit, a first computing unit, and a first storage unit, and the power supply unit of the first power domain is further configured to supply power to the one or more of the second control unit, the first computing unit, and the first storage unit.

13. The control system according to any one of claims 10 to 12, wherein the second power domain further comprises a second computing unit and/or a second storage unit; and
the power supply unit of the second power domain is configured to supply power to the second computing unit and/or the second storage unit.

14. The control system according to any one of claims 10 to 13, wherein the power supply unit of the second power domain comprises a first voltage conversion unit and a second voltage conversion unit, and the control system further comprises a second isolation unit;
the first isolation unit is configured to output the first control signal to the first voltage conversion unit;
the first control unit is further connected to the second isolation unit, and is configured to output a fourth level signal to the second isolation unit; and
the second isolation unit has an input end and an output end; the second isolation unit is configured to: receive the fourth level signal by using the input end of the second isolation unit, and output, under an action of the fourth level signal, a second control signal to the second voltage conversion unit by using the output end of the second isolation unit; and the second control signal is used to control the second voltage conversion unit to be powered on or powered off.

15. The control system according to claim 14, wherein the second isolation unit comprises a second switch, and the second switch has a first end, a second end, and a third end; and
the first end of the second switch serves as the input end of the second isolation unit, and is configured to receive the fourth level signal, wherein the fourth level signal is used to control connected/disconnected states of the second end and the third end of the second switch; the second end of the second switch serves as the output end of the second isolation unit, and is connected to a power supply end and an input end of the second voltage conversion unit; and the third end of the second switch is connected to a ground end.

16. The control system according to claim 15, wherein the first end of the second switch is grounded by using a first resistor, and the second end of the second switch is connected to the power supply end by using a second resistor.

17. The control system according to claim 15 or 16, wherein the second switch comprises a transistor or a field-effect transistor.

18. The control system according to any one of claims 1 to 17, further comprising a third isolation unit and a second controlled unit, wherein
the first control unit is further connected to the third isolation unit, and is configured to output a fifth level signal to the third isolation unit;
the third isolation unit has a first input end, a second input end, and an output end, and the third isolation unit is configured to: receive the fifth level signal and a sixth level signal by using the first input end and the second input end of the third isolation unit respectively, and output a third control signal to the second controlled unit by using the output end of the third isolation unit; and
the second controlled unit is configured to output the sixth level signal to the second input end of the third isolation unit under an action of the third control signal.

19. A control apparatus, comprising a control unit and an isolation unit, wherein
the control unit is connected to the isolation unit, and is configured to output a first level signal to the isolation unit;
the isolation unit has a first input end, a second input end, and an output end, and the isolation unit is configured to: receive the first level signal by using the first input end, receive, by using the second input end, a second level signal output by a controlled unit, and output a control signal to the controlled unit by using the output end; and
the control signal is used to control the controlled unit to output the second level signal.

20. The control apparatus according to claim 19, wherein the isolation unit comprises a switch and a logical operation circuit, the switch has a first end and a second end, and the logical operation circuit has a first input end, a second input end, and an output end;
the first input end of the logical operation circuit serves as the first input end of the isolation unit and is configured to receive the first level signal as a first input signal;
the first end of the switch serves as the second input end of the isolation unit, and is configured to receive the second level signal; and the second end of the switch is connected to the second input end of the logical operation circuit, and is configured to output a second input signal to the second input end of the logical operation circuit when the switch is turned on; and
the logical operation circuit is configured to: perform a logical operation on the first input signal and the second input signal, and output the control signal by using the output end.

21. A control apparatus, comprising a first control unit, a second control unit, and a latching unit, wherein
the first control unit is connected to the latching unit, and is configured to output a first level signal to the latching unit;
the second control unit is connected to the latching unit, and is configured to output a second level signal to the latching unit; and
the latching unit has a first input end, a second input end, and an output end, and the latching unit is configured to: receive the first level signal and the second level signal by using the first input end and the second input end respectively, sample and latch the second level signal under an action of the first level signal, and output a latched signal to a controlled unit by using the output end.

22. The control apparatus according to claim 21, wherein the latching unit comprises an edge trigger.

23. The control apparatus according to claim 21 or 22, wherein the latching unit further has a power supply end; and
the second control unit is further connected to the power supply end of the latching unit, and is configured to control a power-on/off state of the latching unit.

24. A control system, comprising the control apparatus and the controlled unit according to any one of claims 19 to 23.

25. A carrier, comprising the control system according to any one of claims 1 to 18, or the control system according to claim 24.
